(19) Europäisches Patentamt / European Patent Office / Office européen des brevets

(11) **EP 4 749 367 A1**

(12) **EUROPEAN PATENT APPLICATION**

(43) Date of publication:
**27.05.2026 Bulletin 2026/22**

(21) Application number: **24214248.7**

(22) Date of filing: **20.11.2024**

(51) International Patent Classification (IPC):
**G03F 9/00** *(2006.01)* **G03F 7/00** *(2006.01)*

(52) Cooperative Patent Classification (CPC):
**G03F 7/70633; G03F 9/7003; G03F 9/7019; G03F 9/7046**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventor: **HU, Lan, Shen**
**5500 AH Veldhoven (NL)**

(74) Representative: **ASML Netherlands B.V.**
**Corporate Intellectual Property**
**P.O. Box 324**
**5500 AH Veldhoven (NL)**

(54) **A METHOD FOR MODELING METROLOGY DATA OVER A SUBSTRATE AREA AND ASSOCIATED APPARATUSES**

(57) A computer implemented method for modeling metrology data comprising obtaining first layer measurement data sampled on a first layer measurement layout, fitting a first layer model to the first layer measurement data as sampled on the first layer measurement layout to obtain a first fitted first layer model, fitting the first layer model to the first layer measurement data as sampled on a second layer measurement layout to obtain a second fitted first layer model, determining a difference model as the difference of the first fitted first layer model and the second fitted first layer model; and correcting a fitted second layer model using the difference model.

Fig. 6

**Description**

FIELD

The present disclosure relates to processing of substrates for the production of, for example, semiconductor devices.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use radiation. The wavelength of this radiation determines the minimum size of features which can be formed on the substrate. Typical wavelengths currently in use are about 365 nm (i-line), about 248 nm, about 193 nm and about 13 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of about 193 nm.

Low-k1 lithography may be used to process features with dimensions smaller than the classical resolution limit of a lithographic apparatus. In such a process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of a numerical aperture (NA,) a customized illumination scheme, use of one or more phase shifting patterning devices, optimization of the design layout such as optical proximity correction (OPC) in the design layout, or other methods generally defined as resolution enhancement techniques (RET). Additionally or alternatively, one or more tight control loops for controlling a stability of the lithographic apparatus may be used to improve reproduction of the pattern at low k1.

Effectiveness of the control of a lithographic apparatus may depend on characteristics of individual substrates. For example, a first substrate processed by a first processing tool prior to processing by the lithographic apparatus (or any other process step of the manufacturing process, herein referred to generically as a manufacturing process step) may benefit from (slightly) different control parameters than a second substrate processed by a second processing tool prior to processing by the lithographic apparatus.

The accurate placement of patterns on the substrate is a chief challenge for reducing the size of circuit components and other products that may be produced by lithography. In particular, the challenge of measuring accurately the features on a substrate which have already been laid down is a critical step in being able to align successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself. Not all distortions are correctable during exposure, however, and it remains important to trace and eliminate as many causes of such distortions as possible.

These distortions of the wafer grid are represented by metrology data associated with mark position. The metrology data are obtained from measurements of wafers. An example of such measurements are alignment measurements of alignment marks performed using an alignment system in a lithographic apparatus prior to exposure.

It is sometimes desirable to use different target/mark layouts and/or different numbers of targets/marks (i.e., different measurement layouts) for different layers of the same substrate. However, doing this may introduce errors due solely to the different measurement layouts used.

It is therefore desirable to adapt the alignment modeling approach, to counteract errors introduced by the use of different measurement layouts in different layers.

SUMMARY

In a first aspect of the invention there is provided a computer implemented method for modeling metrology data over a substrate area of a substrate in a lithographic process, the method comprising: obtaining first layer measurement data sampled on a first layer measurement layout and relating to a first layer on said substrate; fitting a first layer model to said first layer measurement data as sampled on the first layer measurement layout to obtain a first fitted first layer model; fitting the first layer model to said first layer measurement data as sampled on a second layer measurement layout to obtain a second fitted first layer model; determining a difference model as the difference of said first fitted first layer model and said second fitted first layer model; and correcting a fitted second layer model using said difference model, the fitted second layer model being fitted to second layer measurement data sampled on the second layer measurement layout and relating to a second layer on said substrate.

In a further aspect of the invention, there is provided a computer program comprising program instructions operable to perform the method of the first aspect when run on a suitable apparatus, and associated processing apparatus and lithographic apparatus.

BRIEF DESCRIPTION OF THE DRAWINGS

Embodiments of the invention will now be described, by way of example only, with reference to the accompanying schematic drawings, in which:

Figure 1 depicts a schematic overview of a lithographic apparatus;
Figure 2 depicts a schematic overview of a lithographic cell;
Figure 3 shows schematically the use of the lithographic apparatus and lithographic cell of Figures 1 and 2 together with one or more other apparatuses forming a manufacturing facility for, e.g., semiconductor devices, the facility implementing a control strategy according to an embodiment of the invention;
Figure 4(a) and 4(b) comprise an illustration of the concept of measurement layout mismatch;
Figure 5 is a flow diagram of a method of correcting for measurement layout mismatch according to a first embodiment; and
Figure 6 is a flow diagram of a method of correcting for measurement layout mismatch according to a second embodiment.

DETAILED DESCRIPTION

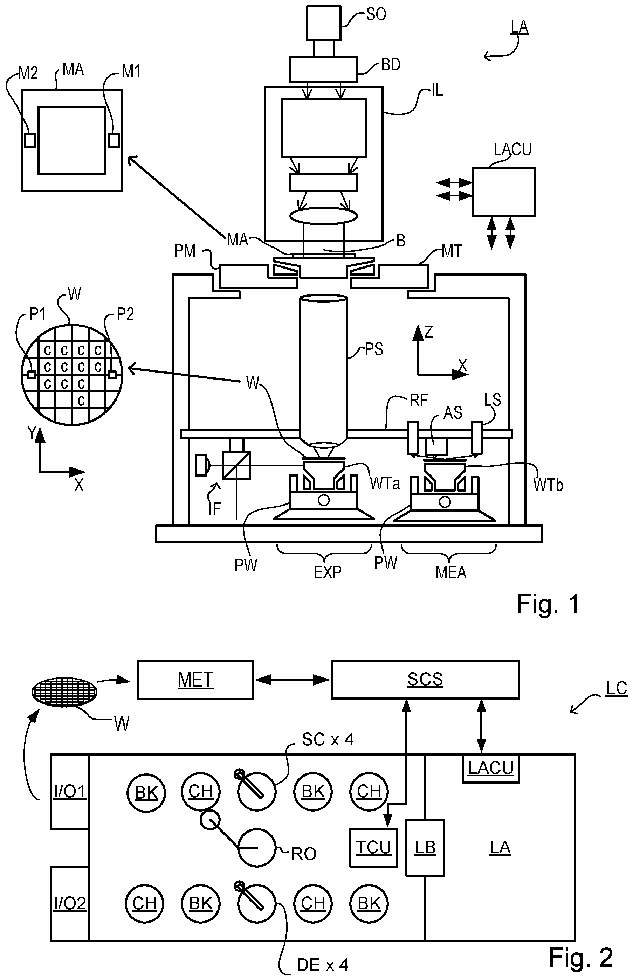

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support (e.g., a mask table) T constructed to support a patterning device (e.g., a mask) MA and connected to a first positioner PM configured to accurately position the patterning device MA in accordance with certain parameters, one or more substrate supports (e.g., a wafer table) WTa and WTb constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in U.S. Patent No. 6,952,253, which is incorporated herein by reference.

Lithographic apparatus LA in this example is of a so-called dual stage type which has two substrate tables WTa and WTb and two stations - an exposure station and a measurement station-between which the substrate tables can be moved. While one substrate on one substrate table is being exposed at the exposure station EXP, another substrate can be loaded onto the other substrate table at, e.g., the measurement station MEA or at another location (not shown) or can be processed at measurement station MEA. A substrate table with a substrate can be located at measurement station MEA so that various preparatory steps may be carried out. The preparatory steps may include mapping the surface height of the substrate using a level sensor LS and/or measuring the position of alignment marks on the substrate using an alignment sensor AS. Due to inaccuracies in creating the marks and also due to deformations of the substrate that occur throughout its processing, the set of marks may next to translation and rotation have undergone more complex transformations. Consequently, in addition to measuring position and orientation of the substrate, the alignment sensor in practice may measure in detail the positions of many marks across the substrate area, if the apparatus LA is to print product features at the correct locations with high accuracy. The measurement of alignment marks can therefore be time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. An embodiment of the invention can be applied in an apparatus with only one substrate table, or with more than two.

In addition to having one or more substrate supports, the lithographic apparatus LA may comprise a measurement stage (not shown). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The apparatus further includes a lithographic apparatus control unit LACU which controls all the movements and measurements of various actuators and sensors of the lithographic apparatus (such as those described). Control unit LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

As shown in Figure 2 the lithographic apparatus LA may form part of a lithographic cell LC, also sometimes referred to as a lithocell or (litho)cluster, which often also includes apparatuses to perform pre- and post-exposure processes on a substrate W. Conventionally these apparatuses includes one or more spin coaters SC to deposit resist layers, one or more developers DE to develop exposed resist, one or more chill plates CH and one or more bake plates BK, e.g. for conditioning the temperature of substrates W e.g. for conditioning solvents in the resist layers. A substrate handler, or robot, RO picks up substrates W from input/output ports I/O1, I/O2, moves them between the different processing apparatuses and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, one or more inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus MET, which may also be referred to as a metrology apparatus or metrology tool, is used to determine one or more properties of the substrates W, and in particular, how one or more properties of different substrates W vary or how one or more properties associated with different layers of the same substrate W vary from layer to layer. The inspection apparatus may be constructed to identify defects on the substrate W and may, for example, be part of the lithocell LC, or may be integrated into the lithographic apparatus LA, or may even be a stand-alone device. The inspection apparatus may measure the one or more properties on a latent image (an image in a resist layer after the exposure), or on a semi-latent image (an image in a resist layer after a post-exposure bake step), or on a developed resist image (in which the exposed or unexposed parts of the resist have been removed), or even on an etched image (after a pattern transfer step such as etching).

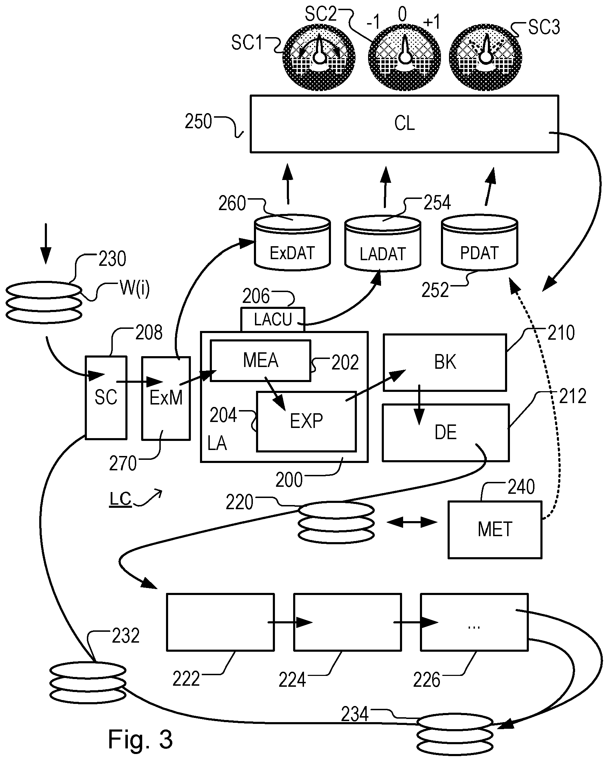

Figure 3 shows the lithographic apparatus LA and the lithocell LC in the context of an industrial manufacturing facility for, e.g., semiconductor products. Within the lithographic apparatus (or "litho tool" 200 for short), the measurement station MEA is shown at 202 and the exposure station EXP is shown at 204. The control unit LACU is shown at 206. As already described, litho tool 200 forms part of a "litho cell" or "litho cluster" that also includes a coating apparatus SC, 208 for applying photosensitive resist and/or one or more other coatings to substrate W for patterning by the apparatus 200. At the output side of apparatus 200, a baking apparatus BK, 210 and developing apparatus DE, 212 are provided for developing the exposed pattern into a physical resist pattern. Other components shown in Figure 3 are omitted, for clarity.

Once the pattern has been applied and developed, patterned substrates 220 are transferred to other processing apparatuses such as are illustrated at 222, 224, 226. A wide range of processing steps are implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses.

The described semiconductor manufacturing process comprising a sequence of patterning process steps is just one example of an industrial process in which the techniques disclosed herein may be applied. The semiconductor manufacturing process includes a series of patterning steps. Each patterning process step includes a patterning operation, for example a lithographic patterning operation, and a number of other chemical and/or physical operations.

The manufacture of semiconductor devices involves many repetitions of such processing, to build up device structures with appropriate materials and patterns, layer-by-layer on the substrate. Modern device manufacturing processes may comprise 40 or 50 individual patterning steps, for example. Accordingly, substrates 230 arriving at the litho cluster may be newly prepared substrates, or they may be substrates that have been processed previously in this cluster 232 or in another apparatus entirely. Similarly, depending on the required processing, substrates on leaving apparatus 226 may be returned for a subsequent patterning operation in the same litho cluster (such as substrates 232), they may be destined for patterning operations in a different cluster (such as substrates 234), or they may be finished products to be sent for dicing and packaging (such as substrates 234).

Each layer of the product structure typically involves a different set of process steps, and the apparatuses used at each layer may be completely different in type. Further, even where the processing steps to be applied by the apparatuses are nominally the same, in a large facility, there may be several supposedly identical machines working in parallel to perform the processing on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. Parallel processing may also be performed in different chambers within a larger apparatus. Moreover, in practice, different layers often involve different etch processes, for example chemical etch, plasma etch, etc., according to the details of the material to be etched, and special requirements such as, for example, anisotropic etching.

The previous and/or subsequent processes may be performed in other lithography apparatuses, as just mentioned, and may even be performed in different types of lithography apparatus. For example, one or more layers in the device manufacturing process which are very demanding in terms of, e.g., resolution and/or overlay may be performed in a more advanced lithography tool than one or more other layers that are less demanding. Therefore, one or more layers may be exposed in an immersion type lithography tool, while one or more others are exposed in a 'dry' tool. One or more layers may be exposed in a tool working at DUV wavelengths, while one or more others are exposed using EUV wavelength radiation.

Also shown in Figure 3 is the metrology apparatus (MET) 240 which is provided for making measurements of parameters of the products at desired stages in the manufacturing process. A common example of a metrology station in a modern lithographic manufacturing facility is a scatterometer, for example an angle-resolved scatterometer or a spectroscopic scatterometer, and it may be applied to measure one or more properties of developed substrates at 220 prior to etching in the apparatus 222. Using metrology apparatus 240, performance parameter data PDAT 252 may be determined. From this performance parameter data PDAT 252, it may be further determined that a performance parameter, such as overlay or critical dimension (CD), does not meet specified accuracy requirements in the developed resist. Prior to the etching step, the opportunity exists to strip the developed resist and reprocess one or more of the substrates 220 through the litho cluster. Moreover, the metrology results from the metrology apparatus 240 can be used to maintain accurate performance of the patterning operations in the litho cluster, by making small adjustments over time, thereby reducing or minimizing the risk of products being made out-of-specification, and requiring re-work. Of course, metrology apparatus 240 and/or one or more other metrology apparatuses (not shown) can be applied to measure one or more properties of the processed substrates 232, 234, and/or of incoming substrates 230.

Typically the patterning process in a lithographic apparatus LA is one of the most significant steps in the processing which involves high accuracy of dimensioning and placement of structures on the substrate W. To help ensure this high accuracy, three systems may be combined in a control environment as schematically depicted in Figure 3. One of these systems is the litho tool 200 which is (virtually) connected to a metrology apparatus 240 (a second system) and to a computer system CL 250 (a third system). A desire of such an environment is to optimize or improve the cooperation between these three systems to enhance an overall so-called "process window" and provide one or more tight control loops to help ensure that the patterning performed by the lithographic apparatus LA stays within a process window. The process window defines a range of values of a plurality of process parameters (e.g. two or more selected from dose, focus, overlay, etc.) within which a specific manufacturing process yields a defined result (e.g. a functional semiconductor device) - typically a range within which the values of the process parameters in the lithographic process or patterning process are allowed to vary while yielding a proper structure (e.g., specified in terms of an acceptable range of CD (such as +- 10% of a nominal CD)).

The computer system CL may use (part of) the design layout to be patterned to predict which one or more resolution enhancement techniques to use and to perform computational lithography simulations and calculations to determine which patterning device layout and lithographic apparatus settings achieve a largest overall process window of the patterning process (depicted in Figure 3 by the double arrow in the first dial SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second dial SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third dial SC3).

Computer system 250 can implement control of the process based on a combination of (i) "pre-processing metrology data" (e.g., including scanner metrology data LADAT 254, and External pre-processing metrology ExDAT 260), associated with substrates before they are processed in a given processing step (for example a lithography step) and (ii) performance data or "post-processing data" PDAT 252 that is associated with the substrates after they have been processed.

A first set of pre-processing metrology data LADAT 254 (referred to herein as scanner metrology data, as it is data generated by the lithographic apparatus LA 200 or scanner) may comprise the alignment data conventionally obtained by the lithographic apparatus LA 200 using alignment sensor AS in the measurement station 202. Alternatively, or in addition to the alignment data, the scanner metrology data LADAT 254 may include height data obtained using level sensor LS, and/or "wafer quality" signals from the alignment sensor AS or the like. As such, the scanner metrology data LADAT 254 may comprise an alignment grid for the substrate, and data relating to substrate deformation (flatness). For example, the scanner metrology data LADAT 254 may be generated by the measurement station MEA 202 of twin stage lithographic apparatus LA 200 (e.g., as this typically comprises the alignment sensor and leveling sensor) in advance of exposure, enabling simultaneous measurement and exposure operations. Such twin stage lithographic apparatus are well known.

Increasingly, (e.g. stand-alone) external pre-exposure metrology tools ExM 270 are used to make measurements before exposure on a lithographic apparatus. Such external pre-exposure metrology tools ExM 270 are distinct from the measurement station MEA 202 of a twin stage lithographic apparatus LA 200. Any pre-exposure measurements performed within the track are also considered to be external measurements. To maintain exposure throughput at a sufficient level, the scanner metrology data LADAT (e.g., alignment grid and substrate deformation grid) measured by measurement station MEA 202 is based on a sparser set of measurements as would be desirable. This typically means such a measurement station is incapable of gathering sufficient metrology data for higher order corrections, and particularly corrections beyond the third order. In addition to this, use of an opaque hard mask can make it difficult to accurately measure the wafer grid in alignment.

External pre-exposure metrology tools ExM 270 enable much denser measurements to be made on each substrate, prior to exposure. Some of these pre-exposure metrology tools ExM 270 measure and/or predict wafer grid deformation at a throughput equal to or faster than the scanner, and with a measurement density much higher than can be achieved using an alignment sensor and level sensor, even when such sensors are comprised within a separate measurement station MEA 202. Pre-exposure metrology tools comprise, for example, substrate shape inspection tools and/or stand-alone alignment stations.

While Figure 3 shows separate storage 252, 254, 260 for each of the performance data PDAT, scanner metrology data LADAT and external pre-exposure data ExDAT, it will be appreciated that these different types of data may be stored in one common storage unit, or may be distributed over a larger number of storage units, from which particular items of data can be retrieved when required.

To represent alignment measurements over a wafer and/or over a field, an alignment model is used. A first purpose of an alignment model is to provide a mechanism for interpolating and/or extrapolating the available measurements data over the whole wafer, such that an expose grid can be created on each exposure field. The metrology data will be sparse as it is simply not practical to measure as many measurement regions as would be desirable from an overlay accuracy perspective: the time and therefore throughput overhead would be too high. A second purpose of an alignment model is to provide noise suppression. This may be achieved by using fewer model parameters than measurements or by using regularization.

While standard models (e.g., linear models) might use fewer than ten parameters (e.g., 6 parameters), advanced or higher order alignment models may use more than 10 parameters, more than 15 parameters, or more than 30 parameters. Examples of advanced models are higher order wafer alignment (HOWA) models and radial basis function (RBF) based alignment models. HOWA is a published technique based on second and higher order polynomial functions. The order number may vary, e.g., it may be second order or higher, third order or higher, fourth order or higher, fifth order or higher etc.. RBF modeling is described in US2012218533A1, which is incorporated herein by reference. Different versions and extensions of these advanced models can be devised (e.g., different modeling orders for HOWA or different regularization for RBF). The advanced models generate a complex description of the wafer grid that is corrected for, during the exposure of the target layer. RBF and latest versions of HOWA provide particularly complex descriptions based on tens of parameters. This implies many measurements are required to obtain a wafer grid with sufficient accuracy.

In addition to the possibility of selecting different alignment models to represent the alignment data, overall exposure (e.g., overlay) performance may also be dependent on the location sampling, regardless of the model(s) used. Location sampling in this context describes the number and/or position of the locations measured over a substrate or a portion thereof (e.g., a field), from which the measurement data (e.g., alignment data) is generated. For example, location sampling may comprise selecting a subset of possible alignment marks (an alignment mark layout) for measurement.

It is known to generate alignment mark layouts using a subsampling optimization (SSO) scheme, which may be used to optimize an alignment mark layout. However, in practice these layouts are not optimal as, typically, a different layout is generated per-layer across the whole wafer. Each layer shows different characteristics and hence each will typically have a different optimal layout.

While it may be generally desirable to be able to define different layouts on each layer to better capture the distortion per layer, the different layouts result in a measurement layout mismatch penalty which has an overlay impact. In other words, it is known that there is an overlay error component directly attributable to a difference in mark layouts of the two layers between which the overlay relates, even when the same model is used. Because of this, a per layer optimization is typically not performed as it results in layout mismatches throughout the layer stack.

Because of this, a hybrid approach is often employed, where a layout is determined as a combination of all optimal alignment marks for all layers, with the number of marks constrained to maximize throughput (or for acceptable throughput). By definition, this results in a compromise layout and therefore performance is not optimal.

In many cases, functional layers (e.g., typically those higher in the stack) have relaxed on-product overlay requirements. This means that they may be able to be exposed to an acceptable standard on different lithographic apparatuses (e.g., lower specification/cheaper apparatuses) and/or exposed with less alignment metrology (fewer locations per layout). However, when using a present hybrid layout strategy, the throughput may be unnecessarily limited due to the chosen mark layout, which typically is optimized for more critical layers (e.g., those lower in the stack). Additionally, some modeling options can be unavailable on such apparatuses, such as RBF based models. This may necessitate a choice of different layouts across a wafer layer stack, resulting in a layout mismatch penalty.

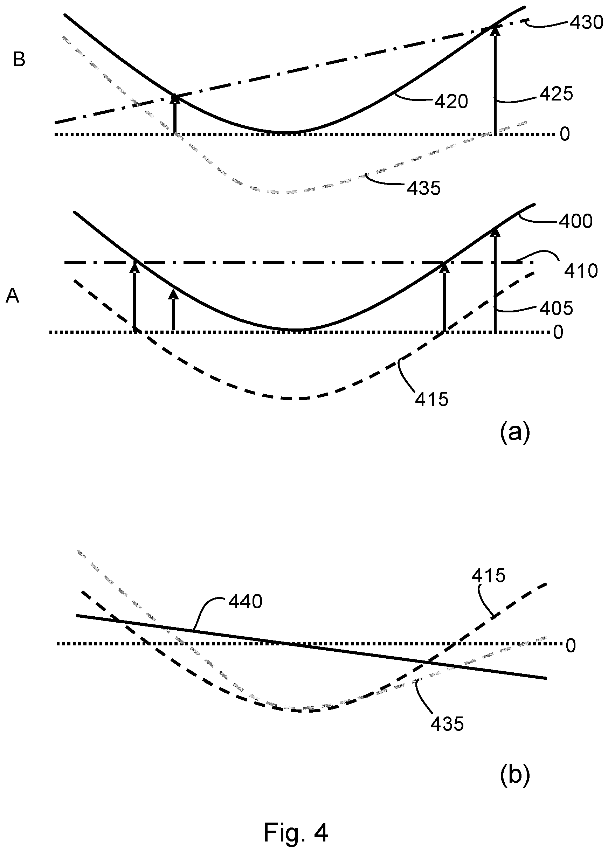

The layout mismatch penalty in this case describes an error component (e.g., a component of on-product overlay) which results from a difference in the measurement layouts of two layers, regardless of whether the same model or different models are fitted to each layer. The layout mismatch penalty is conceptually illustrated in Figure 4(b) and mathematically described by Equation [1] or [2] below. Note that this layout mismatch penalty is different to a model mismatch penalty which results from using different models in the two layers. As such, where different models and different measurement layouts are used, there will be separate overlay impacts resultant from the layout mismatch penalty and the model mismatch penalty. Methods for determining a correction for the model mismatch penalty are described in WO2024199865, incorporated herein by reference. These methods may be employed in combination with the concepts disclosed herein when_different models and different measurement layouts are used in two layers.

It is expected in future that alignment metrology will become much faster (e.g., parallel alignment metrology where multiple alignment heads measure multiple marks simultaneously). This may enable hundreds of alignment marks to be measured per layer with acceptable throughput. This may make it much more desirable to use mismatched mark layouts (i.e., different measurement layouts) across the stack. It has been observed that this layout mismatch penalty tends to scale (e.g., linearly) with the number of mismatched marks. With a larger number of marks, there is a potential for a greater number of mismatched marks between less critical (e.g., upper) layers and more critical (e.g., lower) layers and therefore a greater overlay penalty.

As such, it is extremely desirable to employ mismatched measurement layouts without incurring the layout mismatch penalty. Therefore, to address this issue, a method is proposed which corrects for this overlay penalty attributable to measurement layout mismatch.

The method comprises determining a correction for a second layer fitted model from a difference model comprising a difference of a first fitted first layer model and said second fitted first layer model. The first fitted first layer model comprises the result of fitting the first layer model to first layer measurement data as sampled on the first layer measurement layout, the second fitted first layer model comprises the result of fitting the first layer model to first layer measurement data as sampled on the second layer measurement layout and the fitted second layer model comprises the result of fitting the second layer model to second layer measurement data as sampled on the second layer measurement layout.

The correction may be applied to second layer metrology data or to a second layer fitted model, the second layer fitted model comprising a second layer model having been fitted to the second layer metrology data. The second layer model may be the same as the first layer model, or may be a different model. As such, the concepts herein are equally applicable to situations where the same model or a different model strategy (other than the different measurement layout) is employed for each of the first layer and second layer. Where the models differ, they may differ in order (e.g., linear versus polynomial or different orders of respective polynomial models) or different model types (e.g., polynomial versus RBF).

Where the first layer model and second layer model are the same, the correction may be determined directly from said difference model comprising the difference of the first fitted first layer model sampled on the first layer measurement layout and the second fitted first layer model sampled on the second layer measurement layout. For example, the difference model may be applied directly to (i.e., directly subtracted from) the second layer fitted model; i.e., comprising the same model as the first layer having been fitted to the second layer metrology data measured according to the second layer measurement layout.

Where the first layer model and second layer model are different, the correction may be determined from said difference model, further modeled by the second layer model. This may be achieved, in practice, by determining the difference model, evaluating this difference model on the second layer measurement layout to obtain evaluated difference data and subtracting the evaluated difference data from the second layer measurement data prior to fitting of the second layer model.

It can be appreciated that calculating said difference requires the second layer measurement locations to have been measured when performing the first layer (e.g., alignment) metrology. This will be the case when the second layer measurement layout is a proper subset of the first layer measurement layout, as will often be the case in many practical implementations of the concepts described herein. However, the concepts disclosed herein can be applied when this is not the case, e.g., by extrapolating/interpolating the first layer measurement data to obtain values for the second layer measurement layout to which the first layer model can be fitted. This extrapolating/interpolating of the first layer measurement data may be effected by applying a suitable interpolation model to said first layer measurement data (i.e., as sampled on the first layer measurement layout) and extrapolating/interpolating using this model (e.g., evaluating the fitted interpolation model on the second layer measurement layout). The interpolation model may comprise, for example, an unregularized RBF model or (if different from the first layer model) the second layer model. However other models may be used.

The concepts described herein may be equally applied to an indirect alignment strategy, wherein the first layer and second layer are both aligned to a common layer (zero layer) below these layers, or a direct alignment strategy, where the second layer is aligned directly to the first layer (e.g., which in turn may be aligned to another lower layer). It has been assumed above that the first layer is below (i.e., exposed earlier than) the second layer. In the indirect alignment example, the common layer may comprise, for example, multiple candidate alignment marks of which subsets (measurement layouts) may be chosen per layer.

Figure 4 is a visual simplified example of measurement layout mismatch in the context of indirect alignment. Figure 4(a) shows a first layer (layer A, labeled A in the figure) wafer shape 400 and associated first layer metrology data represented by arrows 405 (only one labeled). In the example shown, there are four arrows representing four measurement locations. A first layer fitted model 410 (in this example a linear model) is shown having been fitted to the first layer metrology data 405. The first layer modeling error 415 comprises the difference between the first layer fitted model 410 and first layer wafer shape 400, i.e., describing the wafer shape content not captured by the model. Also shown is the equivalent for a second layer (layer B, labeled B in the figure); i.e., the second layer wafer shape 420, associated second layer metrology data represented by arrows 425, second layer fitted model 430 (again a linear model) and second layer modeling error 435. It can be seen, however, that the second layer measurement layout is different from that the first layer measurement layout, in that it comprises only two of the four locations of the first layer measurement layout.

Figure 4(b) illustrates the first layer modeling error 415 plotted with the second layer modeling error 435, and the difference 440 of these modeling errors. This difference 440 is the overlay error attributable to the measurement layout mismatch of the first layer (A) and second layer (B), i.e., the layout mismatch penalty.

In the indirect alignment case, it can be shown that overlay $OV$ may be described by:

$$OV = D_B - \widehat{M_B}\left\{\widehat{L^b}\{D_B\}\right\} + \widehat{M_B}\left\{\widehat{L^b}\left\{\widehat{M_A}\left\{\widehat{L^a}\{D_A\}\right\} - \widehat{M_A}\left\{\widehat{L^b}\{D_A\}\right\}\right\}\right\}$$

where $D_A$ is the deformation of the first layer, $D_B$ is the deformation of the second layer, $\widehat{M_A}$ is a first layer model operator, $\widehat{M_B}$ is a second layer model operator, $\widehat{L^a}$ is a first layer measurement layout operator and $\widehat{L^b}$ is a second layer measurement layout operator. Therefore, for example, $\widehat{M_B}\left\{\widehat{L^b}\{D_B\}\right\}$ describes a fitted second layer B model describing the second layer distortion based on second layer measurement layout b. It can be appreciated that, for indirect alignment, first layer deformation $D_A$ substantially equals the first layer measurement data (i.e., first layer signal) $S_A$, and therefore overlay is:

$$OV = D_B - \widehat{M_B}\left\{\widehat{L^b}\{D_B\}\right\} + \widehat{M_B}\left\{\widehat{L^b}\left\{\widehat{M_A}\left\{\widehat{L^a}\{S_A\}\right\} - \widehat{M_A}\left\{\widehat{L^b}\{S_A\}\right\}\right\}\right\}$$

where, for example, $\widehat{M_A}\left\{\widehat{L^a}\{S_A\}\right\}$ describes a fitted first layer model, having been fitted to the first layer measurement data $S_A$ having been sampled on the first layer measurement layout $\widehat{L^a}$. Similarly, $\widehat{M_A}\left\{\widehat{L^b}\{S_A\}\right\}$ describes a fitted first layer model, having been fitted to the first layer measurement data $S_A$ having been sampled on the second layer measurement layout $\widehat{L^b}$. This difference, once determined, is then evaluated on the second layer measurement layout $\widehat{L^b}$ and then modeled by the second layer model $\widehat{M_B}$.

The deformation of the second layer $D_B$ and the second layer model fitted to the second layer distortion $\widehat{M_B}\left\{\widehat{L^b}\{D_B\}\right\}$ are second (current) layer terms and are therefore fundamental to overlay. However the final term $\widehat{M_B}\left\{\widehat{L^b}\left\{\widehat{M_A}\left\{\widehat{L^a}\{S_A\}\right\} - \widehat{M_A}\left\{\widehat{L^b}\{S_A\}\right\}\right\}\right\}$ is the overlay penalty attributable to measurement layout mismatch. In the simplified example of Figure 4(b), the difference 440 equals this term (excluding noise and other factors). As such, the concepts disclosed herein aim to minimize or remove this contribution.

Therefore, the overlay penalty attributable to measurement layout mismatch (layer mismatch penalty) can be described by:

$$\widehat{M_B}\left\{\widehat{L^b}\left\{\widehat{M_A}\left\{\widehat{L^a}\{S_A\}\right\} - \widehat{M_A}\left\{\widehat{L^b}\{S_A\}\right\}\right\}\right\} \quad [1]$$

i.e., the difference, modeled by the second layer model, of the first layer model fitted to the first layer measurement data sampled according to the first layer measurement layout and the first layer model fitted to the first layer measurement data sampled according to the second layer measurement layout. The methods described herein therefore determine this difference and use it to determine a feedforward correction for the second layer alignment.

It can be appreciated that where the same model is used for the first and second layers (i.e., $\widehat{M_B} = \widehat{M_A}$), then overlay is:

$$OV = D_{\mathrm{B}} - \widehat{M_{\mathrm{A}}} \left\{ \widehat{L^b} \{D_{\mathrm{B}}\} \right\} + \widehat{M_{\mathrm{A}}} \left\{ \widehat{L^a} \{S_{\mathrm{A}}\} \right\} - \widehat{M_{\mathrm{A}}} \left\{ \widehat{L^b} \{S_{\mathrm{A}}\} \right\}$$

and the mismatch component is:

$$\widehat{M_{\mathrm{A}}} \left\{ \widehat{L^a} \{S_{\mathrm{A}}\} \right\} - \widehat{M_{\mathrm{A}}} \left\{ \widehat{L^b} \{S_{\mathrm{A}}\} \right\} \qquad [2]$$

Exemplary practical methods embodying these concepts will now be described. Such methods may comprise subtracting this overlay penalty attributable to measurement layout mismatch from the second layer measurement data (e.g., to the second layer measurement data as measured or modeled).

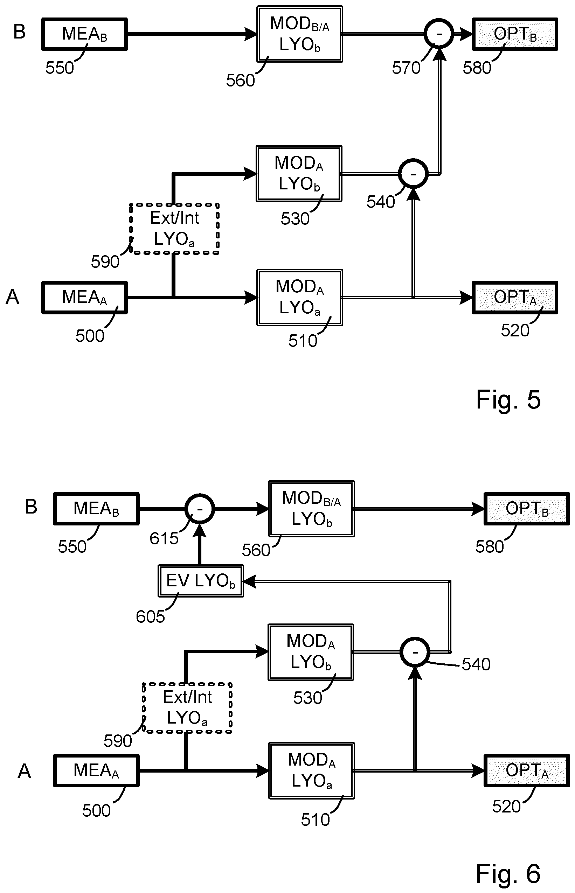

Figure 5 is a flow diagram of such a method of correcting for a layout mismatch error according to a first example. First layer measurement data $MEA_A$ (e.g., first layer alignment data) is sampled 500 according to a first layer measurement layout $LYO_a$. In the example of Figure 5, the first layer is labeled A. A first layer model $MOD_A$ (e.g., a first layer alignment model) is fitted 510 to this first layer measurement data $MEA_A$ on the first layer measurement layout $LYO_a$ and an optimization $OPT_A$ 520 for the layer exposure performed according to known methods (e.g., exposing layer A). At step 530, a first layer model $MOD_A$ is fitted to this first layer measurement data $MEA_A$ on the second layer measurement layout $LYO_b$. A difference model is determined 540 as the difference of the first fitted first layer model determined at step 510 and a second fitted first layer model determined at step 530. For example, the difference model may comprise the result of subtracting the first fitted first layer model from the second fitted first layer model. This difference model may be used as a feed-forward correction for the next layer.

Second layer measurement data $MEA_B$ (e.g., second layer alignment data) is sampled 550 according to a second layer measurement layout $LYO_b$. In the example of Figure 5, the second layer is labeled B. A second layer (e.g., alignment) model $MOD_B$ (or $MOD_A$ if the same model is being fitted to the first and second layer data) is fitted 560 to this second layer measurement data $MEA_B$ The difference model determined at step 540 (i.e., as described by Equation [2]) is subtracted 570 from the fitted second layer model of step 560, thereby correcting for the measurement layout mismatch. The corrected modelled measurement data is then used in optimizing $OPT_B$ the second layer exposure 580 (e.g., exposing layer B).

The method described by Figure 5 is best suited to the situation where the same model is used for both layers, i.e., at both modeling steps 530, 560. The correction will be suboptimal if this is not the case. If the models of the two layers are of a different type (e.g., polynomial and RBF), then this method may not be possible/practical.

Figure 6 is a flow diagram of a method of correcting for a layout mismatch error according to a second example. This example is more generally applicable than the first example of Figure 5, as it is equally effective regardless of whether the models used for the first layer and second layer are different or the same. The majority of the steps are the same as Figure 5 and will not be described again. The main difference is a step 605 of evaluating EV $LYO_b$ the difference model, calculated at step 540, on the second layer measurement layout. Evaluating the difference model means determining values (evaluated difference data) from the model for each of the locations defined by the second layer measurement layout. The resultant evaluated difference data are then subtracted 615 from the second layer measurement data prior to the modeling step 530. This method effectively applies the correction of Equation [1].

In either of the methods of Figures 5 and 6, step 530 requires there to be first layer measurement data corresponding to the second layer measurement layout. This will be the case, for example, when the second layer measurement layout is a proper subset of the first layer measurement layout, as will often be the case. However, the method is not limited to this situation. Where the second layer measurement layout is not a proper subset of the first layer measurement layout and/or there are no measurements performed for one or more of the locations comprised within the second layer measurement layout, an extrapolation and/or interpolation 590 may optionally be performed to estimate values for these one or more unmeasured locations. Such a method may comprise fitting a suitable interpolation model, e.g., an unregularized RBF model or (if different from the first layer model) the second layer model, to said first layer measurement data and extrapolating/interpolating using this model (i.e., evaluating the model at the one or more unmeasured locations of the second layer measurement layout). The estimated values can then be used in the fitting step 530, either in combination with measured values for any common locations in the first layer and second layer measurement layouts, or alone (i.e., where there are no common locations in the first layer and second layer measurement layouts).

The methods described herein are described specifically in the context of determining a correction for layer mismatch penalty. It can also be appreciated that during physical processing of the alignment marks, the process introduces errors onto the mark. This may be referred to as print noise, as once all marks are sampled over the substrate, this error appears as random noise component additive to the alignment data in e.g., in the first layer. However when measured again in the second layer, this print noise component will be the same. What this means is that this print noise is not part of the deformation on the wafer but part of the metrology process. Therefore, it can be appreciated that the methods described herein not only correct for the overlay impact due to deformation on the wafer but also mitigates the overlay impact from the metrology process itself.

In some arrangements, alignment metrology may be performed using a stand-alone or external alignment tool/station, which is external to the lithographic apparatus. This may be done as an alternative to, or supplementary to, alignment metrology within the lithographic apparatus. In such a case, the steps of the methods proposed herein may be performed within such an external alignment tool, within the lithographic apparatus or at a location between the external alignment tool and the lithographic apparatus. Similarly, the method may be implemented within an external (e.g., overlay) metrology tool.

The following clauses describe embodiments of the concepts disclosed herein:

1. A computer implemented method for modeling metrology data over a substrate area of a substrate in a lithographic process, the method comprising:

obtaining first layer measurement data sampled on a first layer measurement layout and relating to a first layer on said substrate;

fitting a first layer model to said first layer measurement data as sampled on the first layer measurement layout to obtain a first fitted first layer model;

fitting the first layer model to said first layer measurement data as sampled on a second layer measurement layout to obtain a second fitted first layer model;

determining a difference model as the difference of said first fitted first layer model and said second fitted first layer model; and

correcting a fitted second layer model using said difference model, the fitted second layer model being fitted to second layer measurement data sampled on the second layer measurement layout and relating to a second layer on said substrate.

2. A method according to clause 1, comprising obtaining the second layer measurement data sampled on the second layer measurement layout; and

fitting a second layer model to said second layer measurement data to obtain said fitted second layer model.

3. A method according to clause 2, comprising measuring said substrate according to said second layer measurement layout to obtain said second layer measurement data.

4. A method according to clause 2 or 3, wherein said correcting step comprises:

evaluating said difference model on said second layer measurement layout to obtain evaluated difference data;

subtracting said evaluated difference data from said second layer measurement data to obtain corrected second layer measurement data; and

performing said step of fitting the second layer model to said corrected second layer measurement data.

5. A method according to clause 1, 2, or 3, wherein said correcting step comprises:
subtracting said difference model from said fitted second layer model.

6. A method according to any preceding clause, wherein the second layer model is different to the first layer model.

7. A method according to any of clauses 1 to 5, wherein the second layer model is the same as the first layer model.

8. A method according to any preceding clause, wherein the second layer measurement layout is a proper subset of the first layer measurement layout.

9. A method according to any of clauses 1 to 7, wherein the second layer measurement layout comprises one or more locations not comprised within the first layer measurement layout, and the method further comprises:
interpolating and/or extrapolating said first layer measurement data to obtain estimated values for said one or more locations not comprised within the first layer measurement layout.

10. A method according to clause 9, wherein said interpolating and/or extrapolating said first layer measurement data comprises:

fitting an interpolation model to the first layer measurement data; and

evaluating the fitted interpolation model on at least said one or more locations not comprised within the first layer measurement layout.

11. A method according to clause 10, wherein the interpolation model comprises an unregularized radial basis function model or, where different from said first layer model, said second layer model.

12. A method according to any preceding clause, comprising measuring said substrate prior to exposure of the first layer according to the first layer measurement layout to obtain said first layer measurement data.

13. A method according to any preceding clause, comprising exposing said first layer using said first fitted first layer model.

14. A method according to any preceding clause, comprising exposing said second layer using said fitted second layer model.

15. A method according to any preceding clause, wherein said first layer measurement data and said second layer measurement data each comprise alignment data.

16. A computer program comprising program instructions operable to perform the method of any of clauses 1 to 15, when run on a suitable apparatus.

17. A non-transient computer program carrier comprising the computer program of clause 16.

18. A processing arrangement comprising:

the non-transient computer program carrier of clause 17; and
a processor operable to run the computer program comprised on said non-transient computer program carrier.

19. An alignment sensor arrangement, comprising:
a processing arrangement operable to perform the method of any of clauses 1 to 15.

20. A lithographic apparatus comprising:

a patterning device support for supporting a patterning device;
a substrate support for supporting a substrate;
the alignment sensor arrangement of clause 19.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.. In that regard, the processed "substrates" may be semiconductor wafers, or they may be other substrates, according to the type of product being manufactured.

Although specific reference may be made in this text to embodiments of the invention in the context of a lithographic apparatus, embodiments of the invention may be used in other apparatus. Embodiments of the invention may form part of a patterning device inspection apparatus, a metrology apparatus, or any apparatus that measures or processes an object such as a wafer (or other substrate) or a mask (or other patterning device). These apparatuses may be generally referred to as lithographic tools. Such a lithographic tool may use vacuum conditions or ambient (non-vacuum) conditions.

In the present document, the terms "radiation" and "beam" are used to encompass all types of radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Although specific reference may have been made above to the use of embodiments of the invention in the context of optical lithography, it will be appreciated that the invention, where the context allows, is not limited to optical lithography and may be used in other applications, for example imprint lithography.

The terms "optimizing" and "optimization" as used herein refers to or means adjusting an apparatus (e.g., a lithography apparatus), a process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A computer implemented method for modeling metrology data over a substrate area of a substrate in a lithographic process, the method comprising:

    obtaining first layer measurement data sampled on a first layer measurement layout and relating to a first layer on said substrate;
    fitting a first layer model to said first layer measurement data as sampled on the first layer measurement layout to obtain a first fitted first layer model;
    fitting the first layer model to said first layer measurement data as sampled on a second layer measurement layout to obtain a second fitted first layer model;
    determining a difference model as the difference of said first fitted first layer model and said second fitted first layer model; and
    correcting a fitted second layer model using said difference model, the fitted second layer model being fitted to second layer measurement data sampled on the second layer measurement layout and relating to a second layer on said substrate.

2. A method as claimed in claim 1, comprising obtaining the second layer measurement data sampled on the second layer measurement layout; and
    fitting a second layer model to said second layer measurement data to obtain said fitted second layer model.

3. A method as claimed in claim 2, wherein said correcting step comprises:

    evaluating said difference model on said second layer measurement layout to obtain evaluated difference data;
    subtracting said evaluated difference data from said second layer measurement data to obtain corrected second layer measurement data; and
    performing said step of fitting the second layer model to said corrected second layer measurement data.

4. A method as claimed in claim 1 or 2, wherein said correcting step comprises:
    subtracting said difference model from said fitted second layer model.

5. A method as claimed in any preceding claim, wherein the second layer model is different to the first layer model.

6. A method as claimed in any of claims 1 to 4, wherein the second layer model is the same as the first layer model.

7. A method as claimed in any preceding claim, wherein the second layer measurement layout is a proper subset of the first layer measurement layout.

8. A method as claimed in any of claims 1 to 6, wherein the second layer measurement layout comprises one or more locations not comprised within the first layer measurement layout, and the method further comprises:
    interpolating and/or extrapolating said first layer measurement data to obtain estimated values for said one or more locations not comprised within the first layer measurement layout.

9. A method as claimed in claim 8, wherein said interpolating and/or extrapolating said first layer measurement data comprises:

fitting an interpolation model to the first layer measurement data; and
evaluating the fitted interpolation model on at least said one or more locations not comprised within the first layer measurement layout.

10. A method as claimed in claim 9, wherein the interpolation model comprises an unregularized radial basis function model or, where different from said first layer model, said second layer model.

11. A method as claimed in any preceding claim, comprising:

exposing said first layer using said first fitted first layer model; and/or
exposing said second layer using said fitted second layer model.

12. A method as claimed in any preceding claim, wherein said first layer measurement data and said second layer measurement data each comprise alignment data.

13. A computer program comprising program instructions operable to perform the method of any of claims 1 to 12, when run on a suitable apparatus.

14. An alignment sensor arrangement, comprising:
a processing arrangement operable to perform the method of any of claims 1 to 12.

15. A lithographic apparatus comprising:

a patterning device support for supporting a patterning device;
a substrate support for supporting a substrate;
the alignment sensor arrangement of claim 14.

Fig. 1

Fig. 2

Fig. 3

Fig. 4

Fig. 5

Fig. 6

Europäisches
Patentamt

European
Patent Office

Office européen
des brevets

# EUROPEAN SEARCH REPORT

**Application Number**

EP 24 21 4248

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | WO 2024/199865 A1 (ASML NETHERLANDS BV [NL]) 3 October 2024 (2024-10-03) * paragraphs [0073] - [0075]; claims 1,2; figure 7 * ----- | 1-15 | INV. G03F9/00 G03F7/00 |
| A | EP 4 439 180 A1 (ASML NETHERLANDS BV [NL]) 2 October 2024 (2024-10-02) * paragraphs [0061], [0062]; figure 7 * ----- | 1-15 | |
| A | US 2022/276575 A1 (HULSEBOS MARIA EDO [NL]) 1 September 2022 (2022-09-01) * paragraphs [0104] - [0110]; figure 6 * ----- | 1-15 | |

**TECHNICAL FIELDS
SEARCHED (IPC)**

G03F

The present search report has been drawn up for all claims

| Place of search | Date of completion of the search | Examiner |
|---|---|---|
| Munich | 9 April 2025 | Weckesser, Jens |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

    ...................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 21 4248

This annex lists the patent family members relating to the patent documents cited in the above-mentioned European search report.
The members are as contained in the European Patent Office EDP file on
The European Patent Office is in no way liable for these particulars which are merely given for the purpose of information.

09-04-2025

| Patent document cited in search report | | Publication date | Patent family member(s) | | Publication date |
|---|---|---|---|---|---|
| WO 2024199865 | A1 | 03-10-2024 | TW | 202443303 A | 01-11-2024 |
| | | | WO | 2024199865 A1 | 03-10-2024 |
| EP 4439180 | A1 | 02-10-2024 | NONE | | |
| US 2022276575 | A1 | 01-09-2022 | CN | 113906345 A | 07-01-2022 |
| | | | JP | 7260669 B2 | 18-04-2023 |
| | | | JP | 2022530567 A | 29-06-2022 |
| | | | KR | 20210141738 A | 23-11-2021 |
| | | | NL | 2025260 A | 18-11-2020 |
| | | | TW | 202109216 A | 01-03-2021 |
| | | | US | 2022276575 A1 | 01-09-2022 |
| | | | WO | 2020224879 A1 | 12-11-2020 |

EPO FORM P0459

For more details about this annex : see Official Journal of the European Patent Office, No. 12/82

**EP 4 749 367 A1**

REFERENCES CITED IN THE DESCRIPTION

**Patent documents cited in the description**

- US 6952253 B
- US 2012218533 A1
- WO 2024199865 A